# EUROPEAN PATENT APPLICATION

(11) **EP 0 766 308 A2**
(43) Date of publication of application: **02.04.1997**
(21) Application number: 96307009.9
(22) Date of filing: 26.09.1996
(51) Int. Cl.: H01L 23/473

(54) **Reduced thermal cycling of water cooled power electronic devices**

(30) Priority: 29.09.1995 US 536587
(71) Applicant: GENERAL ELECTRIC COMPANY, Schenectady, NY 12345 (US)
(72) Inventor: Bailey, Ronald Barry, Erie, Pennsylvania 16511 (US); Butine, John Donovan, Erie, Pennsylvania 16511 (US); Restanio, Joseph Lee, McKean, Pennsylvania 16426 (US)
(74) Representative: Goode, Ian Roy

(57) **Abstract**

A system and method for reducing the average failure rate of power semiconductor devices used in applications in which ambient operating temperature varies over a relatively wide range includes a cooling system which is coupled in heat exchange relationship with the semiconductor devices. The cooling system is operated to maintain a temperature of a coolant above a preselected minimum temperature whereby an operating temperature of the semiconductor devices is maintained above the preselected minimum temperature to reduce cyclical temperature excursion of the semiconductor devices. In one form, the semiconductor devices (10) are mounted in heat exchange relationship with a liquid cooled heat sink and the cooling system (12) includes a heat exchanger (30) for transferring heat from the liquid to external of the system. The cooling system can be operated (26) to bypass (34) the liquid around the heat exchanger when liquid temperature is less than the preselected minimum temperature.

## Description

The present invention relates to a method and apparatus for reducing the average failure rate of electronic semiconductor devices and, more particularly, to a method and apparatus for reducing temperature excursions of such devices during cyclical operation.

Power semiconductor devices such as thyristors are used extensively in electric power control systems for electric motors. For example, diesel electric locomotives, transit vehicles and off highway vehicles typically use thyristors and power inverters for supplying variable frequency alternating current (AC) to AC electric traction motors coupled in driving relationship to wheel axle sets of a locomotive or vehicle. Thyristors are also used in other types of switching converter circuits such as pulse width modulation (PWM) circuits used to regulate power to direct current (DC) and AC electric motors.

One disadvantage of thyristors is the requirement for auxiliary circuitry for switching the thyristors out of conduction. Not only does the auxiliary circuitry make the thyristor inverter/converter more complex but it also includes other components which can fail and thereby reduce system reliability. The electronic power modules which utilize insulated gate bipolar transistors (IGBT) can provide significant improvement in circuit simplification when applied to traction drive inverters or converters that presently use thyristors such as gate turn-off (GTO) devices. However, IGBT modules have internal resistance which result in electrical losses within the modules that are proportional to the amount of inverter power being supplied. When such modules are applied to locomotive or transit vehicle systems which normally operate in a mode where power is applied in a duty cycle mode, the losses within the IGBT modules result in temperature excursions internally within the IGBT module.

The reliability and average life of IGBT modules are dependent on both average junction temperature of the IGBT devices and repetitive junction temperature excursions. More particularly, IGBT modules have limited capability to handle repetitive thermal heating and cooling cycles. Thermal cycle failures generally occur at the interface of dissimilar materials, for example, where a silicone chip within the IGBT module is soldered or otherwise bonded to a ceramic substrate. Module temperature excursions must be minimized in order to prevent thermal cycle failures and in addition the average junction temperature should be limited to a level which provides acceptable operational reliability.

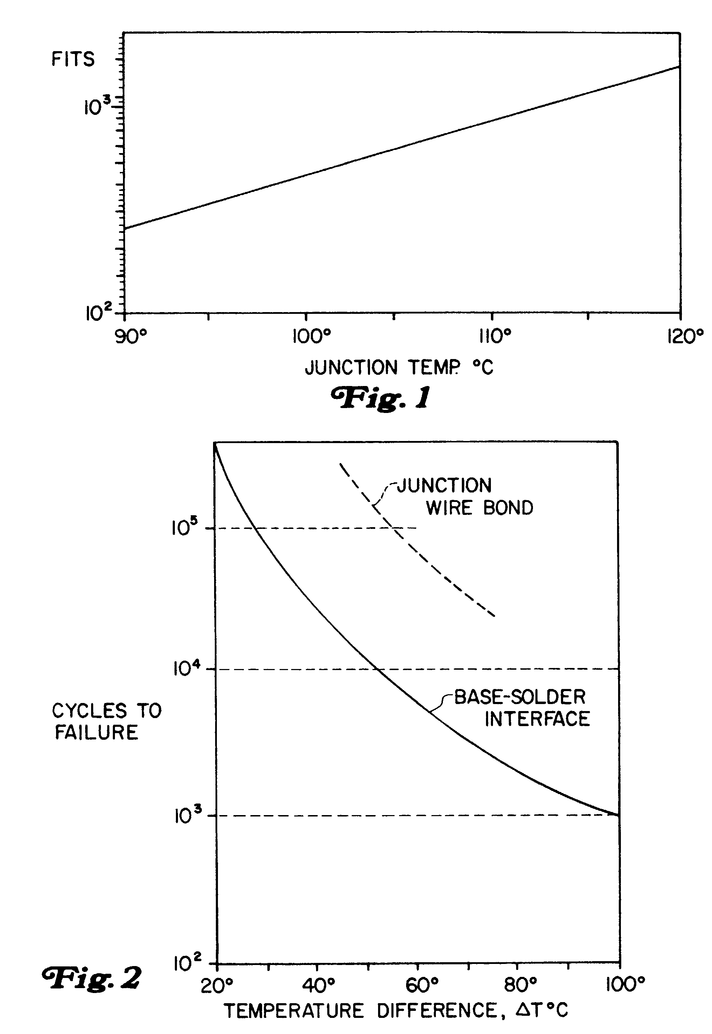

In general, it is desirable to limit the junction temperature rise within an IGBT module to about 70° centigrade above ambient temperature on a steady state basis. For example, if the ambient air temperature is about 25° centigrade, then the junction temperature should be limited to about 95°centigrade on a steady state basis. Concurrently, in order to prolong the life of the IGBT module, it is desirable to limit the junction temperature excursion to a range of about 55° centigrade or less. Of course, minimizing the junction temperature is desirable in order to provide high operational reliability. FIGS. 1 and 2 illustrate typical failure rate curves based on absolute junction temperature in FIG. 1 and junction temperature excursions in FIG. 2 for 5% failure rate. FIG. 1 illustrates failure rates per billion operating hours over a junction temperature range of 90° to 120° centigrade. It can be seen that the failure rate increases logarithmically with increases in temperature. More particularly, at an average junction temperature of about 95°C, the failure rate is approximately 450 failures per billion hours of operation. At a junction temperature of about 115°, the failure rate exceeds 1100 failures per billion hours of operation. Thus, a temperature rise of about 20° centigrade more than doubles the failure rate. In FIG. 2 it can be seen that temperature excursion also creates a failure rate which varies logarithmically with the magnitude of temperature excursion. For example, at a temperature excursion of 100°C between the start of an operating cycle and the end of an operating cycle, the thermal fatigue life of an IGBT device is about 1000 cycles at a 5 percent failure rate. However, if the temperature excursion is held to about 55°C, the thermal fatigue life improves to about 9000 cycles at the 5 percent rate. By lowering the temperature excursion for each cycle, the thermal fatigue life can be increased dramatically. For example, considering a ΔT of 30°, the thermal fatigue life can be increased to about 100,000 cycles at the 5 percent rate. Wire bond failure rate is also shown on this graph.

The obvious solution to improving the failure rate of such IGBT modules would be to design a system having a large water to air heat exchanger providing cooling to the IGBT modules. In a typical water cooled system, the temperature rise from the liquid or water to the IGBT module junction is about 45° centigrade. Accordingly, if the heat exchanger is designed with a maximum temperature rise from ambient air to radiator exit liquid temperature of about 10°centigrade, that rise combined with the 45°C differential between junction temperature and liquid would result in a maximum temperature excursion of 55°C from ambient air temperature to the temperature of the IGBT junction at full power operation. However, creating such a system would defeat the advantages of using the IGBT modules since it would increase the cost of a system to have such a large heat exchanger. Accordingly, it is desirable to create a cooling system for IGBT modules which does not require a large liquid to air heat exchanger and which can maintain the junction temperature of the IGBT module at a desired minimal level and also reduce temperature excursion within the module.

It is an object of the present invention to provide a mechanism for reducing the junction temperature of semiconductor devices using liquid cooling and for reducing junction temperature excursions of such devices with a limited volume heat exchanger.

In an illustrative embodiment, the present system includes a liquid cooled power electronic module, the module including a plurality of semiconductor electric power switching devices such as IGBT devices, the electronic module being coupled for receiving a cooling liquid. The cooling liquid is supplied by a liquid supply system including a heat exchanger, a liquid reservoir, a pump and an associated motor for pumping liquid from the reservoir through the electronic module and the heat exchanger. The system also includes a temperature responsive valve or thermostat coupled in the system such that when the liquid temperature is less than a preselected value, the liquid circulates through the electronic module, the liquid pump and the reservoir without passing through the heat exchanger. When the liquid temperature exceeds the preselected minimum value, the thermostat responds to the higher temperature and closes to force the liquid to be pumped through the heat exchanger to thereby limit the maximum temperature of the liquid. In this embodiment of the invention, when the electronic module is operated at some power level, losses are developed in the module which result in heating of a liquid and a corresponding temperature increase of the liquid. If the power being dissipated within the electronic module creates sufficient heat so that the liquid temperature rises above the preselected minimum value, the valve or thermostat will close and force liquid to flow into the heat exchanger. After power is removed or reduced to the electronic module, the liquid can cool to the preselected minimum temperature at which point the valve or thermostat will open and allow the liquid to be circulated in a path which bypasses the heat exchanger. As a result, the liquid will only cool down to the minimum temperature set by the thermostat or temperature responsive valve. When the level of power applied to the IGBT electronic module is again increased, the starting temperature of the liquid will be at the preselected minimum value as will be the temperature of the electronic module. Consequently, the temperature excursion of the module will be reduced since the starting temperature is at a higher value. This results in the lower thermal cycling of the module and improves the cycle fatigue life. Note that if the initial operation of the electronic module was not sufficient to increase the liquid temperature above the preselected minimum value, the liquid temperature will be at that lower level when the next cycle of the electronic module occurs and can result in a higher temperature excursion. It is also possible that the liquid temperature exceeded the preselected minimum value during the preceding operating cycle of the electronic module and that the liquid temperature did not drop to a level sufficient to cause the thermostat or temperature responsive valve to cycle to its open position. In this instance, the next cycle may occur when the liquid temperature is significantly above the preselected minimum value. This again will result in a reduced thermal excursion of the junction temperature since the initial starting temperature of the liquid is higher. If the heating cycles are close together, the liquid will still be near the selected minimum or threshold temperature when power is reapplied to the electronic module. If there is a long time between heating cycles, the liquid may cool down but then the number of cycles is reduced and the higher junction temperature excursion is acceptable. Although a high temperature limit will minimize thermal cycling, it will also result in higher than average junction temperatures with a higher resulting device failure rate. Thus it is desirable not only to minimize the thermal excursions but also to minimize the average junction temperature.

In still another embodiment of the invention, the system eliminates the thermostat or temperature responsive valve and utilizes a variable speed fan coupled to the heat exchanger such that the speed of the fan can be varied to change the cooling rate of the liquid passing through the heat exchanger. This system is somewhat more complicated than using the temperature responsive thermostat and requires the addition of temperature sensors in the liquid and a variable speed control for the fan motor. Still another option is to provide a variable speed pump for the liquid so that the rate of flow of liquid through the electronic module can be varied. This system suffers from the same disadvantage as the variable speed fan motor in that it requires a temperature sensor and a separate control to vary the speed of the motor driving the pump. However, the latter two methods do offer the advantage of reduced temperature excursion and final junction temperature while reducing the power consumption of the fan or pump.

For a better understanding of the present invention, reference may be had to the following detailed description taken in conjunction with the accompanying drawings in which:
FIG. 1 is a graph of failure rate of a typical IGBT module as a function of junction temperature;
FIG. 2 illustrates thermal fatigue life of a typical IGBT module as a function of temperature excursion;
FIG. 3 is a simplified functional block diagram of a system for controlling electronic module temperature in a liquid cooled electronic module in accordance with one form of the present invention; and
FIGS. 4A and 4B are graphs showing the sensitivity of an IGBT electronic module to various temperature thresholds.

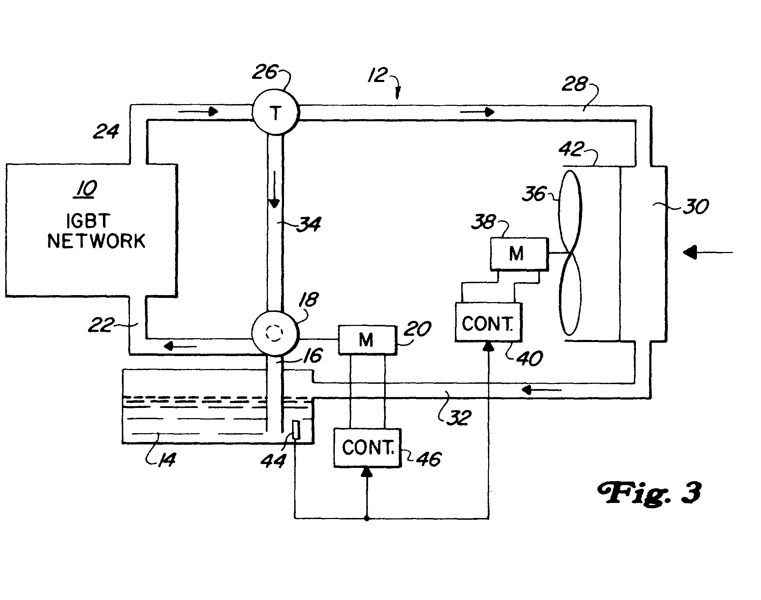

Referring now to FIG. 3, there is shown a cooling system in accordance with one form of the present invention coupled in heat exchange relationship with a power electronic module 10 which may include the aforementioned IGBT devices. The electronic module may take the form of any of those types of modules well known in the art which include a liquid cooled heat sink or other form of liquid cooled heat transfer arrangement with the electronic module. One form of such electronic module and associated liquid cooled system is shown in our co-pending patent application based on USSN 08/538,066. The cooling system, indicated generally at 12 includes a reservoir 14 for containing a preselected level of cooling liquid. Typically, the cooling liquid is water with some percentage of anti-freeze. A conduit 16 leads to a pump 18 driven by an electric motor 20. Pump 18 supplies the liquid through a line 22 to the electronic module 10. After passing in heat exchange relationship with the electronic devices on the electronic module 10, the liquid exits through pipe 24 and passes into a tee connector 26. The tee connector 26 has one outlet that connects through a line 28 to a heat exchanger 30. From the heat exchanger 30, a second line 32 acts as a return line to reservoir 14. At the tee connector 26, a second line 34 from the tee returns to the reservoir 14. The system of FIG. 3 is normally arranged such that the heat exchanger 30 is at a higher elevation than the remaining components of the system. Furthermore, while the system is preferably a closed system in order to prevent contaminants from getting into the cooling liquid, the system is not a pressurized system. Accordingly, in normal operation of the system as shown, the pump will pump the cooling liquid through the module 10 into the outlet pipe 24 into the tee connector 26 and from tee 26 the water would flow through pipe 34 back to reservoir 14. In order to force the liquid to flow into the heat exchanger 30, it is necessary to close the pipe 34 at the tee connector 26. A preferred method of doing this is to install a conventional thermostat such as is used in internal combustion engines in the line 34 at the tee 26. The thermostat is so arranged that when the water temperature is less than a preselected minimum value, for example, 40° centigrade, the thermostat is in an open condition so that the liquid circulates through the pipe 34. Once the temperature of the coolant in reservoir 14 reaches the preselected minimum value such as 40°C, the thermostat closes forcing the liquid flow to continue through the tee 26 into the outlet pipe 28 through the heat exchanger 30. Accordingly, the system thus far described provides a simple mechanical method of regulating the temperature of the liquid in the cooling system to a minimum preselected temperature, for example, preselected 40°centigrade.

An alternate method of controlling the temperature of the liquid coolant in the system 12 to a preselected minimum value is to use a variable speed fan 36 in association with the heat exchanger 30. The fan 36 is driven by a variable speed motor 38 in response to an electronic control 40 of a type well known in the art. Cowling 42 may be placed around the fan 36 so as to direct the air flow from the fan onto the coils of the heat exchanger 30. The motor controller 40 may be responsive to a temperature sensor 44 placed in the reservoir 14 so as to increase the speed of the fan motor 38 as the temperature of the liquid rises above some preselected level. In this form, the liquid temperature is maintained at the higher preselected minimum value by either turning off the fan motor 38 or by reducing its speed using the control 40. A similar effect can be achieved by also using a variable speed motor 20 to control the pump 18. A controller 46 which may be substantially the same as a controller 40 is responsive to the temperature sensor 44 to vary the pump motor speed so as to reduce the rate of flow of the liquid through the system. By reducing the flow rate, the temperature can be allowed to rise to the preselected minimum value and then held substantially at that value by increasing the speed of the motor as the electronic module is called upon to regulate higher levels of power. As previously mentioned, the down side of using the variable speed approach to controlling either the fan motor 38 or pump motor 20 is the cost of the additional electronic controls and sensing of the temperature within the reservoir 14. Obviously, the most economical approach is to use the mechanical arrangement of the thermostat in line 34 to open this pathway for the liquid coolant at the preselected minimum temperature.

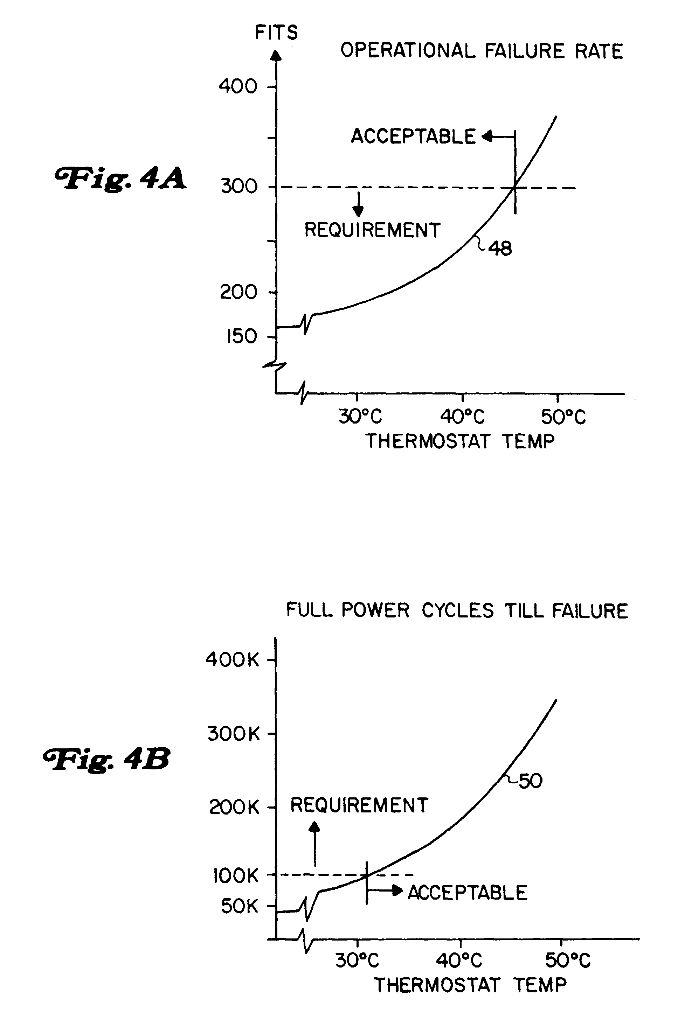

Referring now to FIGS. 4A and 4B, there is shown a graph of the sensitivity of an IGBT device to various temperature thresholds. The ordinate of the graph of FIG. 4A shows the operational failure rate per billion hours when this system is applied to a typical locomotive temperature environment. The ordinate of the graph of FIG. 4B illustrates full power cycles to failure while the abscissa of both graphs indicates various thermostat settings for the thermostat used in the system of FIG. 3. The line indicated at 48 in FIG. 4A represents the operational failure rate calculated using the graph of FIG. 1. Combined with the typical locomotive temperature environment and the effect of the temperature regulation, line 50 in FIG. 4B defines the number of full power cycles to failure that can be achieved using the system of FIG. 3. In particular, lines 48 and 50 are generated from the following tables based upon predictions and calculations of IGBT reliability and thermal life cycles for three different minimum coolant temperatures.

**TABLES**

| IGBT RELIABILITY AND THERMAL CYCLE LIFE | | | | | | | | | |
|---|---|---|---|---|---|---|---|---|---|
| Notes: All temperatures in degC | | | | | | | | | |
| With water controlled to 50 degC minimum | | | | | | | | | |
| Ambient | % of time | Actual water | junct | Delta water | base | junct | FITS | Cycles to failure | |
| | | | | | | | | Solder | Wire |
| 49 | 0.1 | 74 | 119 | 24 | 34 | 69 | 1350 | 55000 | 30000 |
| 43 | 1.5 | 68 | 113 | 18 | 28 | 63 | 950 | 110000 | 65000 |
| 38 | 1.5 | 63 | 108 | 13 | 23 | 58 | 700 | 220000 | 100000 |
| 32 | 8 | 57 | 102 | 7 | 17 | 52 | 510 | 500000 | 170000 |
| 30 | 11 | 55 | 100 | 5 | 15 | 50 | 450 | 1000000 | 250000 |
| 27 | 10 | 52 | 97 | 2 | 12 | 47 | 430 | 1500000 | 380000 |
| 21 | 10 | 50 | 95 | 0 | 10 | 45 | 330 | 2000000 | 400000 |
| 16 | 12 | 50 | 95 | 0 | 10 | 45 | 330 | 2000000 | 400000 |
| 10 | 10 | 50 | 95 | 0 | 10 | 45 | 330 | 2000000 | 400000 |
| 4 | 35 | 50 | 95 | 0 | 10 | 45 | 330 | 2000000 | 400000 |
| | | | | | | Total | 366 | 1111860 | 304150 |

| With water controlled to 30 degC minimum | | | | | | | | | |
|---|---|---|---|---|---|---|---|---|---|
| Ambient | % of time | Actual water | junct | Delta water | base | junct | FITS | Cycles to failure | |
| | | | | | | | | Solder | Wire |
| 49 | 0.1 | 74 | 119 | 25 | 35 | 70 | 1350 | 50000 | 42000 |
| 43 | 1.5 | 68 | 113 | 25 | 35 | 70 | 950 | 50000 | 42000 |
| 38 | 1.5 | 63 | 108 | 25 | 35 | 70 | 700 | 50000 | 42000 |
| 32 | 8 | 57 | 102 | 25 | 35 | 70 | 510 | 50000 | 42000 |
| 30 | 11 | 55 | 100 | 25 | 35 | 70 | 450 | 50000 | 42000 |
| 27 | 10 | 52 | 97 | 22 | 32 | 67 | 430 | 65000 | 50000 |
| 21 | 10 | 46 | 91 | 16 | 26 | 61 | 270 | 130000 | 75000 |
| 16 | 12 | 41 | 86 | 11 | 21 | 56 | 200 | 300000 | 130000 |
| 10 | 10 | 35 | 80 | 5 | 15 | 50 | 140 | 600000 | 210000 |
| 4 | 36 | 30 | 75 | 0 | 10 | 45 | 110 | 2000000 | 400000 |
| | | | | | | Total | 178 | 133791 | 91789 |

| With water controlled to 40 degC minimum | | | | | | | | | |
|---|---|---|---|---|---|---|---|---|---|
| Ambient | % of time | Actual water | junct | Delta water | base | junct | FITS | Cycles to failure | |
| | | | | | | | | Solder | Wire |
| 49 | 0.1 | 74 | 119 | 25 | 35 | 70 | 1350 | 50000 | 42000 |
| 43 | 1.5 | 68 | 113 | 25 | 35 | 70 | 950 | 50000 | 42000 |
| 38 | 1.5 | 63 | 108 | 23 | 33 | 68 | 700 | 60000 | 45000 |
| 32 | 8 | 57 | 102 | 17 | 27 | 62 | 510 | 120000 | 68000 |
| 30 | 11 | 55 | 100 | 15 | 25 | 60 | 450 | 180000 | 90000 |
| 27 | 10 | 52 | 97 | 12 | 22 | 57 | 430 | 250000 | 110000 |
| 21 | 10 | 46 | 91 | 6 | 16 | 51 | 270 | 550000 | 190000 |
| 16 | 12 | 41 | 85 | 1 | 11 | 46 | 200 | 1800000 | 400000 |
| 10 | 10 | 40 | 85 | 0 | 10 | 45 | 190 | 2000000 | 400000 |
| 4 | 36 | 40 | 85 | 0 | 10 | 45 | 190 | 2000000 | 400000 |
| | | | | | | Total | 246 | 366803 | 166712 |

From an examination of the data from which line 48 and 50 are produced, it can be seen that as the temperature excursion of the IGBT junction is reduced, the number of cycles to failure increases.

In general, the higher the minimum temperature setting of the liquid coolant, the less excursion in the cycle temperature and thus the more cycles that are required before failure. However, in comparison with the curve 48, it can be seen that there is a cross-over point at which the operational failure rate due to the higher temperature will override the effects of the reduced temperature excursions. Thus there is a compromise between the setting of the minimum average temperature and the temperature cycle excursion. The best compromise appears to be to set the temperature at about 40°. For purposes of analysis, it is assumed that at maximum power dissipation and steady state conditions, the temperature rise of the liquid coolant will be 25° centigrade above ambient, the solder interface within the module will be 10° centigrade above the liquid coolant and the junction temperature will be 45° centigrade above the liquid coolant.

What has been described is a method for improving reliability of electronic modules such as modules including IGBT devices by reducing temperature excursion of the devices during power cycles while at the same time balancing the reduced temperature excursions against a maximum junction temperature for the devices. In so doing, it has been shown that the reliability of the devices can be improved using a simple mechanical construction of the coolant system for the liquid cooled devices.

## Claims

1. A method for reducing the average failure rate of power semiconductor devices used in applications in which ambient operating temperature varies over a relatively wide range, the method comprising the steps of:
coupling a cooling system in heat exchange relationship with the semiconductor devices; and
operating the cooling system to maintain a temperature of the cooling system above a preselected minimum temperature whereby an operating temperature of the semiconductor devices is maintained above the preselected minimum temperature to reduce cyclical temperature excursion of the semiconductor devices.

2. The method of claim 1 wherein the cooling system comprises a liquid cooled system and the step of coupling includes the step of mounting the semiconductor devices in heat exchange relationship with a liquid cooled heat sink.

3. The method of claim 2 wherein the cooling system includes a heat exchanger for transferring heat from the liquid to external of the system and wherein the step of operating the cooling system includes the step of bypassing the liquid around the heat exchanger when liquid temperature is less than the preselected minimum temperature.

4. A liquid cooled power electronic system including an electronic module containing a plurality of semiconductor electric power switching devices, a liquid cooled heat sink mounted in heat exchange relationship with the electronic module, a liquid supply system connected in liquid communication with the heat sink, the liquid supply system including a heat exchanger for regulating liquid temperature to at least a preselected minimum temperature during operation of said switching devices.

5. The system of claim 4 wherein said liquid supply system includes means for bypassing liquid around the heat exchanger when liquid temperature is less than the preselected minimum temperature.

6. The system of claim 5 wherein said bypass valve comprises a temperature responsive valve.

7. The system of claim 4 wherein said heat exchanger comprises a radiator and a motor driven fan for forcing a flow of air onto the radiator.

8. The system of claim 7 and including a pump for moving liquid through said liquid supply system.

9. The system of claim 8 wherein said motor driven fan is a variable speed fan and including means responsive to liquid temperature for adjusting fan speed to regulate liquid temperature to the preselected minimum value.

10. The system of claim 8 wherein said pump is a variable speed pump for regulating liquid flow rate and including means responsive to liquid temperature for adjusting pump speed to regulate liquid temperature to the preselected minimum value.
